# EUROPEAN PATENT APPLICATION

(11) **EP 0 905 762 A1**
(43) Date of publication of application: **31.03.1999**
(21) Application number: 97830480.6
(22) Date of filing: 30.09.1997
(51) Int. Cl.: H01L 21/48, B08B 7/00

(54) **Method for removing moulding residues in the fabrication of plastic packages for semiconductor devices**

(71) Applicant: STMicroelectronics S.r.l., 20041 Agrate Brianza (Milano) (IT)
(72) Inventor: Crema, Paolo, 20059 Vimercate (Milano) (IT); Tiziani, Roberto, 20014 Nervicano (Milano) (IT)
(74) Representative: Maggioni, Claudio

(57) **Abstract**

A method is described for removing residues of plastic (14) from metal parts (11, 12) of plastic packages of semiconductor devices, i.e. heat-sinks and terminals. The surfaces to be treated are subjected to pulsed laser radiation. The wavelength is chosen in such a way that residues of plastic in thin films have good transparency to the radiation and that the metal has a high absorption capacity in respect of the radiation. Moreover, the intensity and duration of application of the radiation are such as to cause the formation of plasma at the point of impact of the radiation with the surface to be treated.

## Description

The present invention relates to the fabrication of semiconductor devices and, more particularly, to a method for removing residues of moulding material from metal parts of plastic packages for semiconductor devices as is defined in the preamble of Claim 1.

As is known, many semiconductor power devices (discrete transistors and integrated circuits) are contained in packages consisting basically of a plastic body, of terminal conductors issuing from the plastic body and of a metal plate. The function of the latter is to dissipate the heat produced by the device during its operation or to promote its transfer to the exterior and it is usually mounted in contact with a flat surface of an external sink of large dimensions.

For the fabrication of a device of this type, a chip of semiconductor material is fixed to the metal plate which acts as a heat-sink; a metal frame is then mounted on the plate electrically insulated therefrom; the frame, obtained by blanking from sheet metal, comprises metal strips, intended to become the terminals of the device, and interconnection bars between the strips; thin wires are soldered, on the one hand, to appropriate areas of the chip and, on the other hand, to the ends of the metal strips. The resulting structure is mounted, together with other identical structures, in a special mould with one face of the heat-sink in contact with a flat surface of the mould. Next, a plastic, for example a thermosetting epoxy resin, is introduced, in the liquid state, into the mould. After the polymerization of the resin, a body of solid plastic is extracted from the mould, this body enclosing the whole of the structure with the exception of that face of the heat-sink which has remained in contact with the flat surface of the mould, of parts of the metal strips and of the interconnection bars between them. These latter are cut off in a subsequent manufacturing phase.

During the moulding operation, in many cases, the liquid-state resin penetrates between the heat-sink and mould on account of small irregularities in one or other of the surfaces in contact, due, for example, to a slight curvature of the heat-sink or to the wearing of the mould. Therefore, after extraction from the mould, the package may exhibit residues of moulding material, i.e. of cured resin, on the heat-sink. Similar infiltrations may occur on the metal strips with the consequent formation of residues on these also, especially near the plastic body.

The residues of plastic on the heat-sink have to be removed since, otherwise, they would reduce the surface of contact with an external sink or with a metal plate of a printed circuit onto which the heat-sink is to be soldered. The residues on the terminals also have to be eliminated since they impede the cutting off of the interconnection bars and the subsequent operation of bending the terminals.

Various methods for removing such residues of moulding material are known. For example, electrical or chemical treatments are known which can be used with advantage on the terminals, but which do not lend themselves to being used on the heat-sinks. Sand-blasting treatments are also known which enable even thick residues to be removed from the heat-sink and from the terminals, but, because of their very energetic mechanical action, they do not lend themselves to being used in the treatment of plastic packages of small dimensions with very thin and very closely spaced terminals.

The purpose of the present invention is to make available a method for removing residues of moulding material from metal parts of plastic packages which does not mechanically stress the parts to be treated and can therefore also be used in the treatment of plastic packages with thin terminals.

This purpose is achieved by putting into practice the process defined and characterized in general in the first claim.

The idea upon which the present invention is based is the use of laser radiation, i.e. of coherent monochromatic radiation, for the controlled application of high-intensity energy. Although the use of lasers in the treatment of materials and in industrial manufacture has been known for some time, it has not hitherto been contemplated in respect of the removal of residues of moulding material from plastic packages, probably because it was deemed unsuitable for the purpose. Indeed, direct application of laser radiation to the residues to be removed is problematic on account of the difficulty of controlling the action of a laser ray with the necessary accuracy to act only on the heat-sink or only on its terminals, i.e. without also attacking the plastic body.

The method according to the invention does not require great accuracy of location of the laser beam since the effect which causes the removal of the residues is due basically to an alteration of the surface state of the metal part due to the radiation, so that the attack on the moulding material is selective and limited essentially to the residues remaining on the metal part.

The invention and the advantages which derive therefrom will become clear from the following description of an illustrative and hence non-limiting implementation thereof, given in conjunction with the attached drawing, in which:
- Figure 1 is a perspective view of a plastic package as it appears after moulding and
- Figure 2 shows a cross-section of the package of Figure 1 and, diagrammatically, a rig for putting the method of the invention into practice.

The package represented in the drawings comprises a body made of plastic 10, for example an epoxy resin with carbon particles as additive, a multiplicity of terminal conductors, made for example of copper or nickel-plated copper, 11 and a metal plate, made for example of copper or nickel-plated copper, 12 whose function is to dissipate heat and to support a chip of semiconductor material, the latter not being visible since it is completely enclosed within the plastic body. The terminals 11 are joined together by interconnection bars 13 intended to be eliminated by a subsequent cutting operation. Normally, in this manufacturing phase the terminals of the package are linked to the terminals of other packages formed by the same operation and the same mould and are separated only in the subsequent cutting operation. However, so as not to needlessly complicate the drawing, the terminals of a single package are represented. For the same reason a package with 10 terminals only has been represented. In many practical cases there are many more terminals. For example, a typical package, having a width of 12 mm, a length of 15 mm and a height of 3 mm, has 36 terminals arranged in two rows of 18 terminals, each terminal being 0.3 mm wide and 0.25 mm thick.

Residues of plastic 14 due to the infiltration of resin in the liquid state during moulding are shown on that face of the heat-sink 12 which is intended to be mounted in contact with a flat metal element. These residues take the form of more or less thin films of material. Since the carbon particles added to the resin usually have for the most part dimensions greater than 10 µm, when the film is very thin, i.e. less than 10 µm thick, the carbon particles are practically absent and the film is almost transparent to visible light.

Residues 14 are shown also on some terminals near the body 10.

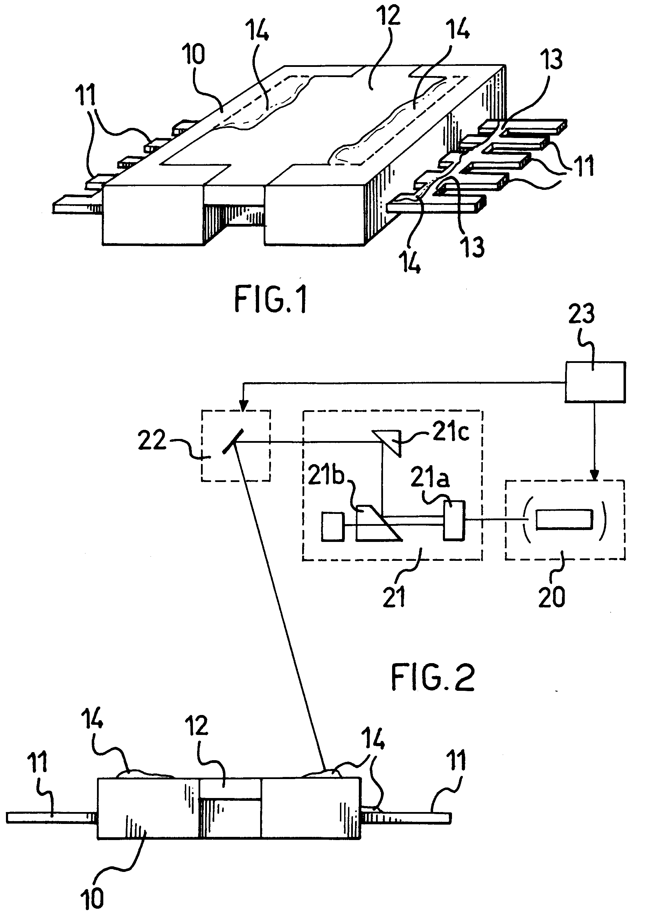

In Figure 2 the package of Figure 1 is represented in a side view, with the plastic residues 14 shown with a deliberately exaggerated thickness so as to clarify the drawing. The rig for removing the residues of plastic consists essentially of a laser 20, a block 21 for frequency conversion and for splitting and deflecting the laser ray, an optical scanning device 22 and a synchronization unit 23.

In the example of the practical realization of the method according to the invention the laser was of the neodymium YAG type consisting basically of a neodymium-doped yttrium and aluminium crystal in the form of a rod furnished with mirrors at its ends, which irradiates at a wavelength of 1,064 nm (infrared light) with pulses whose duration was between 6 and 8 ns and with an energy of around 800 mJoules per pulse. The pulse repetition frequency was around 30 Hz. The output ray from the laser 20 was applied to a frequency converter 21a, consisting of a KH₂PO₄ (deuterated potassium dihydrogen phosphate) crystal which, with a conversion efficiency of around 30-35%, gave at output a ray with double the frequency of the input ray, i.e. with half the wavelength, equal to 532 nm (green visible light). A dichroic mirror 21b separated the ray of double frequency from the residual ray at the output frequency of the laser, diverting it onto a mirror 21c which, in turn, diverted it to the scanning device 22. The latter consisted of an optical system capable of controllably directing the 532 nm laser ray onto predetermined areas of the surface to be treated, in this example the regions of the heat-sink 12 covered with residues of plastic 14. The synchronization unit 23 synchronized the emission of the laser pulses with the scanning.

With the operating conditions indicated above, the epoxy resin films thinner than 10 µm exhibited a transparency of around 20% and the metal used for the heat-sink (copper) exhibited an absorption of around 50%. The laser ray had an intensity, i.e. an energy per unit area, such as to cause the formation of plasma with each pulse. (It seems that the plasma originates from the transformation of the metal atoms and metal oxide atoms located on that surface of the heat-sink which was struck by the high-intensity radiation). The formation of plasma was associated with vaporization of at least part of the residue material present on the impact surface in a circular area of around 2 mm in diameter.

The radiation also had an effect of direct attack on the resin, in particular on residues of thickness equal to or greater than 10 µm which were able to absorb the radiation to a large extent.

Since the degree of removal of material was dependent on the energy absorbed at the point of impact, the duration of application of the radiation, i.e. the number of pulses applied per unit area, was calculated as a function of the thickness of the residues to be eliminated. Thin plastic films (1-10 µm) were eliminated with a single pass of the ray in successive steps of 1 mm, while thicker residues (10-25 µm) required from 2 to 4 passes. The heating up of the heat-sink was negligible.

The direct action of the laser ray on the plastic on those surfaces of the plastic body which were struck by the ray on account of their being immediately adjacent to the heat-sink turned out to be negligible, so that accurate control of the scan area did not prove to be necessary. Indeed, with the method according to the invention the physical phenomenon which determines the removal of moulding material through vaporization caused by the formation of plasma on the metal surface owing to the strong absorption of energy by the metal has a greater effect than direct attack due to the ray incident on the moulding material.

Clearly, the method of the invention lends itself equally well to the removal of the residues of plastic from the terminals. It should be noted moreover that this method, both when used, of course, to treat the heat-sink and when used to treat the terminals, does not cause any significant mechanical stress on the terminals, so that they do not suffer any deformation in this phase of manufacture.

Whereas a single realization of the invention has been illustrated and described, it is clear that numerous variations and modifications are possible within the scope of the same inventive concept. For example, it would be possible to use laser devices of a different type to that described above, such as a krypton fluoride excimer laser which irradiates with pulses 25 ns wide with a wavelength of 248 nm (ultraviolet), or other types of pulsed laser preferably with a wavelength of between 180 and 700 nm and with pulses of between 3 and 30 ns wide.

## Claims

1. Method for removing residues of moulding material from metal parts of plastic packages of semiconductor devices, characterized in that at least one surface region of a metal part (12) covered with residues (14) of moulding material is subjected to pulsed laser radiation, the wavelength of which is chosen in such a way that the moulding material, when it forms residues of a thickness less than a predetermined value, is at least partially transparent to the radiation and in that the metal parts are at least partially absorbent in respect of the radiation, the intensity of the radiation and the duration of application of the radiation being chosen in such a way that the radiation causes the formation of plasma at the point of impact with the said surface region.

2. Method according to Claim 1, in which the wave-length of the laser radiation is chosen also in such a way that the moulding material, when it forms residues (14) of a thickness equal to or greater than the said predetermined value, is able to absorb the radiation to a large extent, the intensity of the radiation and the duration of application of the radiation being moreover chosen in such a way that the radiation causes a direct attack of the moulding material.

3. Method according to Claim 1 or 2, in which the laser radiation has a wavelength of between 180 and 700 nm.

4. Method according to any one of the preceding claims, in which the pulses of the laser radiation have a duration of between 3 and 30 ns.

5. Method according to any one of the preceding claims, in which the operation of subjecting to laser radiation at least one surface region of a metal part comprises a scanning of the laser radiation over the surface region and the duration of application of the radiation is determined by the number of radiation pulses applied per unit area.

6. Method according to Claim 5, in which the scanning motion is synchronized with the emission of the pulses.

7. Method according to any one of the preceding claims, used in the fabrication of plastic packages with metal parts (11, 12), in which the moulding material is an epoxy resin with carbon particles as additive.

8. Method according to Claim 7, in which the carbon particles have for the most part dimensions greater than 10 µm and in which the said predetermined value of the thickness of the moulding material is around 10 µm.

9. Method according to any one of the preceding claims, in which the metal parts (11, 12) comprise copper parts.

10. Method according to any one of the preceding claims, in which the metal parts comprise nickel-plated copper parts.
